# EUROPEAN PATENT APPLICATION

(11) **EP 3 051 574 A1**
(43) Date of publication of application: **03.08.2016**
(21) Application number: 14849128.5
(22) Date of filing: 24.09.2014
(51) Int. Cl.: H01L 21/02, H01L 21/304

(54) **SUBSTRATE TREATMENT DEVICE, METHOD FOR SEPARATING BONDED SUBSTRATE, AND METHOD FOR REMOVING ADHSEIVE**

(30) Priority: 25.09.2013 JP 2013198340
(71) Applicant: Shibaura Mechatronics Corporation, Yokohama-shi, Kanagawa 247-8610 (JP)
(72) Inventor: KANAI, Takahiro, Yokohama-shi Kanagawa 247-8610 (JP); MATSUI, Emi, Yokohama-shi Kanagawa 247-8610 (JP); HAYASHI, Konosuke, Yokohama-shi Kanagawa 247-8610 (JP)
(74) Representative: Awapatent AB
(86) International application number: PCT/JP2014/075263
(87) International publication number: WO 2015/046235

(57) **Abstract**

The embodiment of a substrate treatment device includes a treatment bath configured to store a treatment liquid in which a treatment object is to be immersed, a transport section configured to transport the treatment object, a temperature control section provided in at least one of the treatment bath and a position spaced from the treatment bath and configured to perform at least one of heating and cooling of the treatment object.
the treatment object is at least one of:
a laminated substrate including a device substrate, a support substrate, and an adhesive provided between the device substrate and the support substrate,
the device substrate with the adhesive attached thereto, and
the support substrate with the adhesive attached thereto.

## Description

### [Technical Field]

Embodiments of the invention relates to a substrate treatment device, a peering method for laminated, and a method for removing adhesive.

### [Background Art]

A multi-chip package (MCP) has been put to use in recent years. In the multi-chip package, a plurality of semiconductor elements (semiconductor chips) are stacked in one package using e.g. bonding wires and through-silicon vias (TSV).

The semiconductor element used in such a multi-chip package typically has a thinner thickness dimension than the ordinary semiconductor element.

Furthermore, the thickness dimension of the semiconductor element tends to be thinner also from the viewpoint of e.g. increase in the degree of integration of semiconductor devices.

Manufacturing of such a semiconductor element having a thin thickness dimension requires e.g. thinning the thickness dimension of the substrate before dicing. However, thinning the thickness dimension of the substrate decreases the mechanical strength. Thus, the substrate may break when processing the substrate to a thin thickness dimension.

Thus, the strength necessary for e.g. processing the substrate to a thin thickness dimension is provided as follows. A substrate with a pattern formed thereon (hereinafter referred to as device substrate) is bonded to a support substrate to form a laminated substrate. After processing for the thickness dimension, the device substrate is peeled from the support substrate (see, e.g., Patent Literature 1).

However, the device substrate is difficult to peel from the support substrate.

Furthermore, simply peeling the device substrate from the support substrate may leave part of the adhesive on the support substrate and the device substrate.

In this case, part of the adhesive left on the support substrate makes it difficult to directly reuse the support substrate.

Part of the adhesive left on the device substrate may make it difficult to perform the subsequent steps (such as dicing).

### [Citation List]

### [Patent Literature]

[Patent Literature 1] JP-A-2010-531385

### [Summary of Invention]

### [Technical Problem]

The problem to be solved by the invention is to provide a substrate treatment device, a peeling method for a laminated substrate, and a method for removing an adhesive capable of facilitating peeling the adhesive.

### [Technical Solution]

The embodiment of a substrate treatment device includes a treatment bath configured to store a treatment liquid in which a treatment object is to be immersed, a transport section configured to transport the treatment object, a temperature control section provided in at least one of the treatment bath and a position spaced from the treatment bath and configured to perform at least one of heating and cooling of the treatment object.
the treatment object is at least one of:
a laminated substrate including a device substrate, a support substrate, and an adhesive provided between the device substrate and the support substrate,
the device substrate with the adhesive attached thereto, and
the support substrate with the adhesive attached thereto.

### [Effect of the invention]

The substrate treatment device, the peeling method for the laminated substrate, and the method for removing the adhesive capable of facilitating peeling the adhesive is provided by the embodiment of the invention.

### [Brief Description of Drawings]

[FIG. 1]

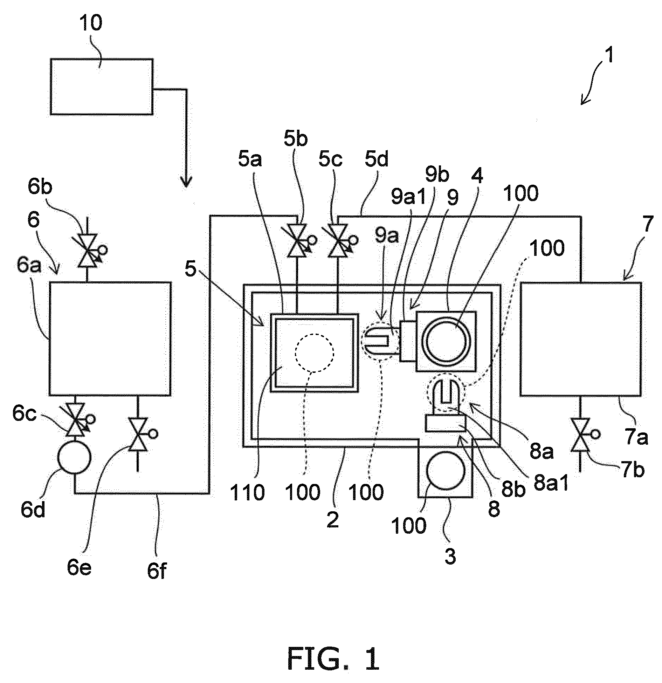

   FIG. 1 is a schematic view for illustrating a substrate treatment device 1 according to a first embodiment.
[FIG. 2]

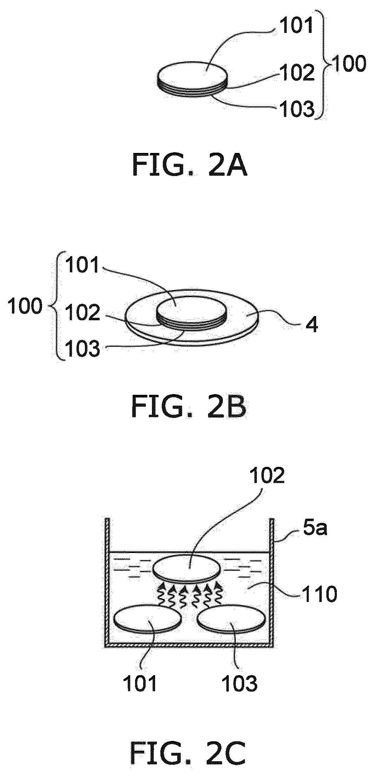

   FIGS. 2A to 2C are schematic views for illustrating the function of the substrate treatment device 1 and the peeling method for the laminated substrate 100.
[FIG. 3]

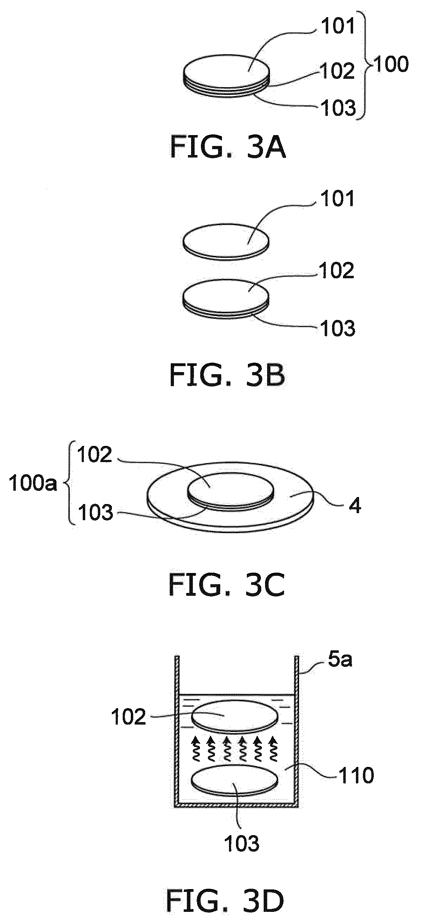

   FIGS. 3A to 3D are schematic views for illustrating the function of the substrate treatment device 1 and the method for removing the adhesive 102.
[FIG. 4]

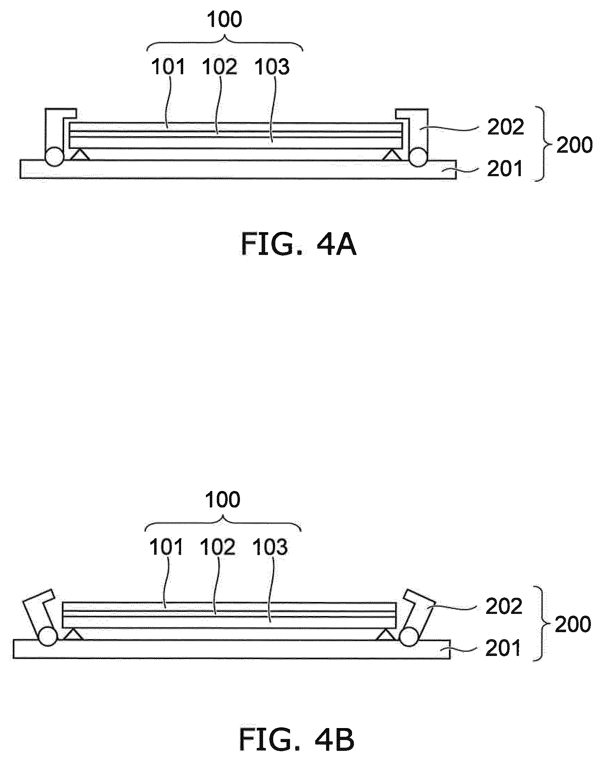

   FIG. 4A is a schematic view for illustrating the state in which the laminated substrate 100 is held by a holding hook 202.
   FIG. 4B is a schematic view for illustrating the state in which the holding hook 202 is disengaged.
[FIG. 5]

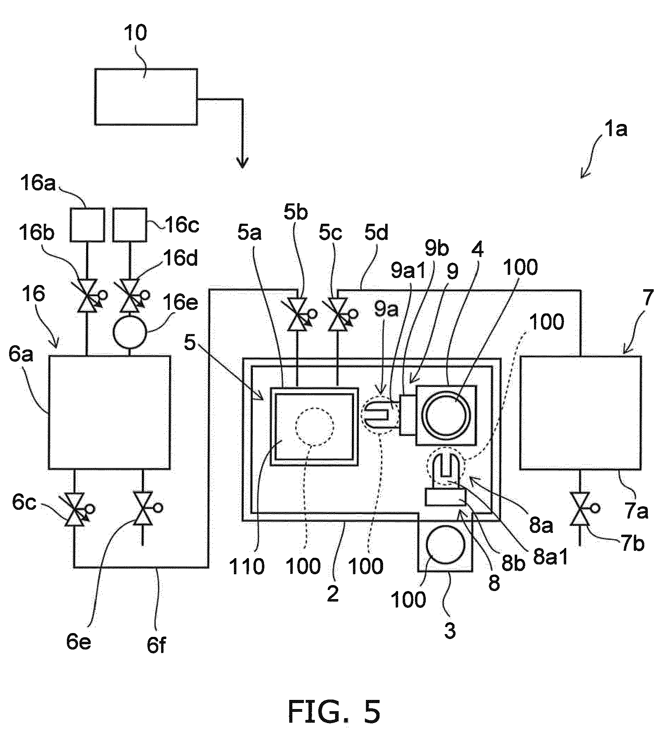

   FIG. 5 is a schematic view for illustrating a substrate treatment device 1a according to a second embodiment.
[FIG. 6]

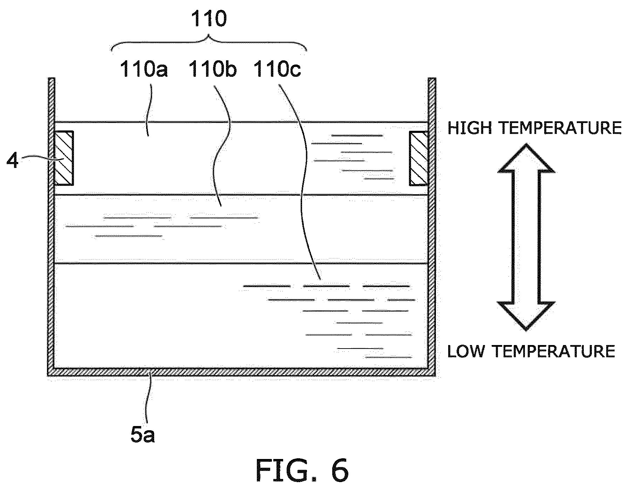

   FIG. 6 is a schematic sectional view for illustrating the treatment liquid 110 provided with regions having different temperatures.

### [Description of Embodiments]

Various embodiments will be described hereinafter with reference to the accompanying drawings. In the respective drawings, the same components are labeled with like reference numerals, and detailed description thereof is omitted as appropriate.

### (First embodiment)

FIG. 1 is a schematic view for illustrating a substrate treatment device 1 according to a first embodiment.

The substrate treatment device 1 can perform peeling of a laminated substrate 100 and removal of an adhesive 102 from the substrate 100 with the adhesive 102 attached thereto (see, e.g., FIGS. 2A to 3D).

In this case, for instance, as shown in FIGS. 2A and 3A, the laminated substrate 100 includes a device substrate 101 with a pattern formed thereon, a support substrate 103, and an adhesive 102. The adhesive 102 is provided between the device substrate 101 and the support substrate 103, and bonds the device substrate 101 to the support substrate 103.

The following example illustrates the case of treating the laminated substrate 100. However, this is also applicable to the case of treating a substrate 100a with an adhesive 102 attached thereto.

As shown in FIG. 1, the substrate treatment device 1 includes a container 2, a housing section 3, a temperature control section 4, a treatment section 5, a supply section 6, a recovery section 7, a transport section 8, a transport section 9, and a control section 10.

The container 2 can be shaped like a box having an air-tight structure. The air-tight structure only needs to be able to prevent e.g. intrusion of external particles. Furthermore, a pressurization device, not shown, can also be provided to make the internal pressure of the container 2 slightly higher than the external pressure. Providing the pressurization device, not shown, to make the internal pressure of the container 2 slightly higher than the external pressure facilitates suppressing intrusion of external particles.

The housing section 3 is detachably attached from outside to the opening provided in the sidewall of the container 2. The end part on the container 2 side of the housing section 3 is configured to be openable, and to enable passing of a laminated substrate 100 through the opening. The housing section 3 includes holders, not shown, for holding laminated substrates 100 in a stacked (multistage) configuration. That is, the housing section 3 can house a plurality of laminated substrates 100 in a stacked (multistage) configuration.

The housing section 3 can be e.g. a FOUP (front-opening unified pod). The FOUP is a front-opening carrier used in mini-environment semiconductor plants and intended for transport and storage of substrates.

The laminated substrate 100 housed in the housing section 3 is a laminated substrate 100 before treatment and a laminated substrate 100 after treatment.

The number of housing sections 3 is not limited to one, but two or more housing sections 3 may be provided.

In the case illustrated in FIG. 1, the temperature control section 4 is provided on the inner bottom surface of the container 2. The upper surface of the temperature control section 4 is a mounting surface for mounting the laminated substrate 100. The temperature control section 4 includes therein a heating device or cooling device, not shown. Thus, the temperature control section 4 can change the temperature of the laminated substrate 100 mounted on the upper surface of the temperature control section 4. That is, the temperature control section 4 performs at least one of heating and cooling of the laminated substrate 100 (substrate 100a).

The heating device or cooling device, not shown, provided in the temperature control section 4 is not particularly limited. The heating device, not shown, can be appropriately selected from various types such as using Joule heat, circulating a heat medium, and using radiation heat. The cooling device, not shown, can be appropriately selected from various types such as using the Peltier effect and circulating a heat medium.

The temperature control section 4 is controlled by the control section 10 and can adjust the temperature of the laminated substrate 100.

The temperature control section 4 may control the temperature so that the in-plane temperature distribution of the laminated substrate 100 is made uniform. Alternatively, the temperature control section 4 may control the temperature so that the in-plane temperature distribution of the laminated substrate 100 is made nonuniform.

The in-plane temperature distribution of the laminated substrate 100 may be made nonuniform. That is, a plurality of regions having different temperatures may be formed in the surface of the laminated substrate 100. In this case, for instance, the surface of the laminated substrate 100 is divided into a plurality of regions. Then, the temperature can be adjusted in each of the plurality of regions.

The following example illustrates the case in which the laminated substrate 100 is heated by the temperature control section 4.

The treatment section 5 includes a treatment bath 5a, a supply valve 5b, a supply valve 5c, and a piping 5d.

The treatment bath 5a is shaped like a box and provided on the inner bottom surface of the container 2. The treatment bath 5a has a liquid-tight structure. The treatment bath 5a stores therein a treatment liquid 110. The upper end of the treatment bath 5a is opened. Thus, the treatment bath 5a is configured so that the laminated substrate 100 can be immersed in the treatment liquid 110 stored inside the treatment bath 5a. The treatment liquid 110 is brought into contact with the adhesive 102. Thus, the treatment liquid 110 has the function of weakening the adhesion strength by e.g. dissolving (decomposing) or softening the adhesive 102.

The treatment liquid 110 can be e.g. pure water (DIW, deionized water), ozone water, supersaturated gas solution, APM (ammonia/hydrogen peroxide mixture), or SPM (sulfuric acid/hydrogen peroxide mixture). In the case where the treatment liquid 110 is not pure water, the concentration of the treatment liquid 110 can be set to a concentration not affecting the product quality of the device substrate 101.

The treatment liquid 110 can be appropriately selected depending on the component of the adhesive 102.

For instance, the adhesive 102 includes an organic material. Then, it is preferable to select a treatment liquid 110 having a decomposition function for the organic material.

Then, peeling of the laminated substrate 100 or removal of the adhesive 102 can be performed more effectively.

The treatment liquid 110 having a decomposition function for the organic material is e.g. ozone water, APM, or SPM.

In the case where the adhesive 102 is made of an inorganic material, any of the illustrated treatment liquids 110 may be used.

Use of a supersaturated gas solution can produce a gas in the peeled portion or crack described later.

The gas dissolved in the supersaturated gas solution is not particularly limited. The gas dissolved in the supersaturated gas solution can be e.g. air, nitrogen gas, oxygen gas, or ozone gas.

In the treatment bath 5a under the atmospheric pressure, the gas dissolved in the supersaturated gas solution produces bubbles. When the bubble bursts, the bubble produces a physical force. By using this physical force, peeling of the laminated substrate 100 or removal of the adhesive 102 can be performed more effectively.

The treatment liquid 110 can be a solution having a larger specific weight than the adhesive 102. Then, the film-like adhesive 102 peeled from the laminated substrate 110, described later, is likely to float on the surface of the treatment liquid 110. Thus, the peeled film-like adhesive 102 can be easily removed.

The details on peeling of the laminated substrate 100 and removal of the adhesive 102 will be described later.

The supply valve 5b is provided on the sidewall of the treatment bath 5a. The treatment liquid 110 is supplied into the treatment bath 5a through the supply valve 5b.

The supply valve 5b controls supply and stoppage of the treatment liquid 110. Furthermore, the supply valve 5b can be configured to control the flow rate of the treatment liquid 110, besides supply and stoppage of the treatment liquid 110.

The supply valve 5b can always maintain a constant amount of the treatment liquid 110 stored inside the treatment bath 5a based on the signal from the liquid-level meter, not shown, provided on the treatment bath 5a.

The supply valve 5c is provided on the bottom surface side of the sidewall of the treatment bath 5a. The supply valve 5c is connected to a tank 7a through the piping 5d.

The supply valve 5c controls supply and stoppage of the treatment liquid 110. Furthermore, the supply valve 5c can be configured to control the flow rate of the treatment liquid 110, besides supply and stoppage of the treatment liquid 110.

For instance, in the case of e.g. exchanging the treatment liquid 110 stored in the treatment bath 5a and performing maintenance of the treatment section 5, the treatment liquid 110 stored inside the treatment bath 5a is drained into the tank 7a through the supply valve 5c.

The supply section 6 includes a tank 6a, a supply valve 6b, a supply valve 6c, a liquid feeder 6d, a drain valve 6e, and a piping 6f.

The tank 6a stores the treatment liquid 110 before being used for treatment.

The supply valve 6b is provided on the sidewall of the tank 6a. The treatment liquid 110 is supplied into the tank 6a through the supply valve 6b.

The supply valve 6b controls supply and stoppage of the treatment liquid 110. Furthermore, the supply valve 6b can be configured to control the flow rate of the treatment liquid 110, besides supply and stoppage of the treatment liquid 110.

The supply valve 6b can always maintain a constant amount of the treatment liquid 110 stored in the tank 6a based on the signal from the liquid-level meter, not shown, provided on the tank 6a.

The supply valve 6c is provided on the bottom surface side of the sidewall of the tank 6a. The treatment liquid 110 is supplied to the outside of the tank 6a through the supply valve 6c.

The supply valve 6c controls supply and stoppage of the treatment liquid 110. Furthermore, the supply valve 6c can be configured to control the flow rate of the treatment liquid 110, besides supply and stoppage of the treatment liquid 110.

One end of the liquid feeder 6d is connected to the supply valve 6c. The other end of the liquid feeder 6d is connected to the supply valve 5b through the piping 6f. The liquid feeder 6d feeds the treatment liquid 110 stored inside the tank 6a into the treatment bath 5a. The liquid feeder 6d can be e.g. a pump resistant to the treatment liquid 110.

The drain valve 6e is provided on the bottom surface side of the sidewall of the tank 6a. The drain valve 6e can be connected to e.g. the drain piping of the plant or the tank 7a. For instance, when performing maintenance of the supply section 6, the treatment liquid 110 stored inside the tank 6a is drained outside through the drain valve 6e.

The recovery section 7 includes a tank 7a and a drain valve 7b.

The tank 7a stores the treatment liquid 110 drained from the treatment bath 5a. That is, the tank 7a stores the treatment liquid 110 after being used for treatment.

The drain valve 7b is provided on the bottom surface side of the sidewall of the tank 7a. The drain valve 7b can be connected to e.g. the drain piping of the plant.

The transport section 8 is provided on the inner bottom surface of the container 2. The transport section 8 is located between the housing section 3 and the temperature control section 4.

The transport section 8 includes a holder 8a and a mover 8b.

The holder 8a includes an arm 8a1 having a joint. The holder 8a can hold a laminated substrate 100 at the tip of the arm 8a1.

The mover 8b performs e.g. expansion and contraction of the arm 8a1 of the holder 8a, and rotation of the holder 8a.

For instance, the mover 8b expands and contracts the arm 8a1 by bending the arm 8a1. Thus, the mover 8b passes a laminated substrate 100 from the temperature control section 4 to the housing section 3, or passes a laminated substrate 100 from the housing section 3 to the temperature control section 4. The mover 8b rotates the holder 8a in the state of holding the laminated substrate 100 at the tip of the arm 8a1 and directs the tip of the arm 8a1 to the housing section 3 or the temperature control section 4.

The transport section 9 is provided on the inner bottom surface of the container 2. The transport section 9 is located between the temperature control section 4 and the treatment bath 5a.

The transport section 9 includes a holder 9a and a mover 9b.

The holder 9a includes an arm 9a1 having a joint. The holder 9a can hold a laminated substrate 100 at the tip of the arm 9a1.

The mover 9b performs e.g. expansion and contraction of the arm 9a1 of the holder 9a, and rotation of the holder 9a.

For instance, the mover 9b expands and contracts the arm 9a1 by bending the arm 9a1. Thus, the mover 9b passes a laminated substrate 100 from the temperature control section 4 to the treatment bath 5a, or passes a laminated substrate 100 from the treatment bath 5a to the temperature control section 4. The mover 9b rotates the holder 9a in the state of holding the laminated substrate 100 at the tip of the arm 9a1 and directs the tip of the arm 9a1 to the temperature control section 4 or the treatment bath 5a. Then, for instance, the mover 9b expands and contracts the arm 9a1 by bending the arm 9a1. Thus, the mover 9b immerses the laminated substrate 100 in the treatment liquid 110 inside the treatment bath 5a, or extracts the laminated substrate 100 immersed in the treatment liquid 110 inside the treatment bath 5a.

The control section 10 controls the operation of each component provided in the substrate treatment device 1.

For instance, the control section 10 controls the transport section 8 to transport and pass the laminated substrate 100 between the housing section 3 and the temperature control section 4. The control section 10 controls the temperature control section 4 so that the temperature of the laminated substrate 100 falls within a prescribed range. The control section 10 controls the transport section 9 to transport and pass the laminated substrate 100 between the temperature control section 4 and the treatment bath 5a. The control section 10 controls the supply valve 5b, the supply valve 6c, and the liquid feeder 6d to supply the treatment liquid 110 from the tank 6a to the treatment bath 5a.

Next, a peeling method for the laminated substrate 100 and a method for removing the adhesive 102 according to this embodiment are illustrated in conjunction with the function of the substrate treatment device 1.

FIGS. 2A to 2C are schematic views for illustrating the function of the substrate treatment device 1 and the peeling method for the laminated substrate 100.

FIGS. 3A to 3D are schematic views for illustrating the function of the substrate treatment device 1 and the method for removing the adhesive 102. That is, FIGS. 3A to 3D show the case of removing the adhesive 102 from the substrate 100a with the adhesive 102 attached thereto.

As shown in FIGS. 2A and 3A, the laminated substrate 100 includes a device substrate 101 with a pattern formed thereon, a support substrate 103, and an adhesive 102. The adhesive 102 is provided between the device substrate 101 and the support substrate 103, and bonds the device substrate 101 to the support substrate 103.

FIG. 3B shows the case of performing peeling of the laminated substrate 100 without using the substrate treatment device 1. For instance, the laminated substrate 100 is heated to soften the adhesive 102. In this state, the device substrate 101 is peeled from the support substrate 103. When peeling of the laminated substrate 100 is performed without using the substrate treatment device 1, part of the adhesive 102 may be left on at least one substrate as shown in FIG. 3B. FIG. 3B illustrates the case where part of the adhesive 102 is left on the support substrate 103. However, part of the adhesive 102 may be left on the device substrate 101.

The following example illustrates the case of treating the laminated substrate 100 or the support substrate 103 (substrate 100a) with the adhesive 102 attached thereto. However, this is also applicable to the case of treating the device substrate 101 with the adhesive 102 attached thereto.

First, as shown in FIGS. 2B and 3C, by the transport section 8, the laminated substrate 100 (substrate 100a) before treatment is extracted from the housing section 3 and mounted on the temperature control section 4.

Next, by the temperature control section 4, the laminated substrate 100 (substrate 100a) is heated so that the temperature of the laminated substrate 100 (substrate 100a) falls within a prescribed range.

The heating temperature of the laminated substrate 100 (substrate 100a) is not particularly limited.

However, in this embodiment, the heating temperature of the laminated substrate 100 (substrate 100a) is set to a temperature higher than the temperature of the treatment liquid 110 inside the treatment bath 5a. In this case, the heating temperature of the laminated substrate 100 (substrate 100a) only needs to fall within the range capable of producing e.g. a peeling or crack described later.

The heating temperature of the laminated substrate 100 (substrate 100a) can be appropriately determined by e.g. experiment or simulation.

The heating only needs to be performed so that a peeling or crack due to difference in linear expansion coefficient described later is produced at at least one of the interface between the device substrate 101 and the adhesive 102, and the interface between the support substrate 103 and the adhesive 102. Thus, the heating does not need to be performed uniformly.

In this case, heating may be performed so that the central region and the outer peripheral region of the laminated substrate 100 (substrate 100a) are different in temperature. In the case where the temperature of the outer peripheral region is made higher than the temperature of the central region, peeling due to difference in linear expansion coefficient between the substrate 101, 103 and the adhesive can be made larger in the outer peripheral region. This can facilitate intrusion of the peeling liquid from the outer peripheral region. On the other hand, in the case where the temperature of the central region is made higher than the temperature of the outer peripheral region, peeling can be made larger in the central region less prone to intrusion of the peeling liquid. This can facilitate intrusion of the peeling liquid into the central region.

Furthermore, heating may be performed so that the temperature changes (an uneven temperature distribution occurs) in the horizontal direction (in-plane direction) of the laminated substrate 100 (substrate 100a).

Next, as shown in FIGS. 2C and 3D, by the transport section 9, the laminated substrate 100 (substrate 100a) is extracted from the temperature control section 4. Then, the laminated substrate 100 (substrate 100a) is immersed in the treatment liquid 110 inside the treatment bath 5a.

The heated laminated substrate 100 (substrate 100a) is immersed in the treatment liquid 110. Thus, the laminated substrate 100 (substrate 100a) is quenched.

Here, the linear expansion coefficient of the device substrate 101 is different from the linear expansion coefficient of the adhesive 102. The linear expansion coefficient of the support substrate 103 is different from the linear expansion coefficient of the adhesive 102.

This produces a thermal stress based on the difference in linear expansion coefficient. Thus, a peeling or crack occurs at at least one of the interface between the device substrate 101 and the adhesive 102, and the interface between the support substrate 103 and the adhesive 102.

Then, the treatment liquid 110 intrudes from e.g. the peeled portion or crack. Thus, peeling of the laminated substrate 100 or removal of the adhesive 102 is performed.

That is, due to formation of e.g. the peeled portion or crack, the treatment liquid 110 is more likely to intrude into the interface between the device substrate 101 and the adhesive 102, and the interface between the support substrate 103 and the adhesive 102. This can facilitate peeling of the laminated substrate 100 or removal of the adhesive 102, i.e., peeling of the adhesive 102.

Next, by the transport section 9, the device substrate 101 and the support substrate 103 separated from the laminated substrate 100 (or the substrate 100a) are extracted from inside the treatment bath 5a.

When the laminated substrate 100 (substrate 100a) is immersed in the treatment liquid 110 inside the treatment bath 5a, for instance, the laminated substrate 100 (substrate 100a) can be housed in a container, not shown, having a meshed inner wall.

The extraction from inside the treatment bath 5a can be performed as follows, for instance.

The extraction from inside the treatment bath 5a can be performed after the lapse of an immersion time previously determined by experiment or simulation.

The separated device substrate 101 and support substrate 103 are pulled up from the treatment liquid 110 together with the container, not shown.

By the transport section 9, the separated device substrate 101 and support substrate 103 are each extracted from the container, not shown.

The extracted device substrate 101 and support substrate 103 are sequentially passed to the temperature control section 4 by the transport section 9.

In this case, the device substrate 101 or the support substrate 103 does not need to be heated by the temperature control section 4.

If the laminated substrate 100 is not separated or the adhesive 102 is insufficiently removed, then heating is performed again by the temperature control section 4, and the aforementioned procedure is repeated. Thus, peeling of the laminated substrate 100 or removal of the adhesive 102 can be performed continuously.

Next, by the transport section 8, the device substrate 101 or the support substrate 103 is extracted from the temperature control section 4. After drying by a drying means, not shown, the device substrate 101 or the support substrate 103 is housed in the housing section 3.

In this case, drying by the drying means, not shown, can be performed before passing to the temperature control section 4. After drying, the device substrate 101 or the support substrate 103 may be directly housed in the housing section 3 without being passed to the temperature control section 4.

Alternatively, the device substrate 101 or the support substrate 103 may be extracted from inside the treatment bath 5a by the transport section 9, and the extracted substrate may be passed from the transport section 9 to the transport section 8. Then, the device substrate 101 or the support substrate 103 may be housed in the housing section 3 by the transport section 8.

Alternatively, the device substrate 101 or the support substrate 103 may be extracted from inside the treatment bath 5a by the transport section 9, and the device substrate 101 or the support substrate 103 may be directly housed in the housing section 3.

In the above embodiment, when the laminated substrate 100 (substrate 100a) is immersed in the treatment liquid 110 inside the treatment bath 5a, the laminated substrate 100 (substrate 100a) is housed in a container, not shown, having a meshed inner wall. However, the laminated substrate 100 (substrate 100a) can be held by a holding member. This holding member holding the laminated substrate 100 (substrate 100a) can be immersed in the treatment liquid 110 inside the treatment bath 5a.

FIG. 4A is a schematic view for illustrating the state in which the laminated substrate 100 is held by a holding hook 202.

FIG. 4B is a schematic view for illustrating the state in which the holding hook 202 is disengaged.

As shown in FIGS. 4A and 4B, the holding member 200 includes a base part 201 for mounting the laminated substrate 100, and a holding hook 202 driven so as to pivot with respect to the base part 201. This holding member 200 receives the laminated substrate 100 (substrate 100a) from the transport section 9. Then, the holding hook 202 is closed. In the state of holding the laminated substrate 100 (substrate 100a), the holding member 200 descends in the treatment bath 5a and immerses the laminated substrate 100 (substrate 100a) in the treatment liquid 110 inside the treatment bath 5a. After the lapse of a prescribed immersion time, the holding member 200 moves to the ascent end and disengages the holding hook 202. Then, the transport section 9 extracts each of the separated device substrate 101 and support substrate 103 from the holding member 200. The subsequent procedure is similar to that of the aforementioned embodiment.

### (Second embodiment)

FIG. 5 is a schematic view for illustrating a substrate treatment device 1a according to a second embodiment.

In the substrate treatment device 1 described above, the previously produced treatment liquid 110 is stored in the tank 6a of the supply section 6. The treatment liquid 110 stored in the tank 6a is supplied to the treatment bath 5a.

In contrast, in the substrate treatment device 1a according to the second embodiment, the treatment liquid 110 is produced inside the tank 6a of the supply section 16. The produced treatment liquid 110 is supplied to the treatment bath 5a.

As shown in FIG. 5, the substrate treatment device 1a includes a container 2, a housing section 3, a temperature control section 4, a treatment section 5, a supply section 16, a recovery section 7, a transport section 8, a transport section 9, and a control section 10.

The supply section 16 includes a tank 6a, a supply valve 6c, a drain valve 6e, a piping 6f, a gas supply section 16a, a supply valve 16b, a liquid supply section 16c, a supply valve 16d, and a liquid feeder 16e.

The gas supply section 16a supplies a gas used to produce the treatment liquid 110.

For instance, in the case where the treatment liquid 110 is ozone water, the gas supply section 16a supplies ozone gas.

In the case where the treatment liquid 110 is a supersaturated gas solution, the kind of the supplied gas is not particularly limited. In the case where the treatment liquid 110 is a supersaturated gas solution, the gas supply section 16a supplies e.g. air, nitrogen gas, oxygen gas, or ozone gas.

The gas supply section 16a can be e.g. a cylinder storing a high-pressure gas.

The gas is supplied from the gas supply section 16a to the tank 6a. Thus, the treatment liquid 110 is pumped from the tank 6a into the treatment bath 5a.

The supply valve 16b is provided on the sidewall of the tank 6a. The gas supplied from the gas supply section 16a is introduced into the tank 6a through the supply valve 16b.

The supply valve 16b controls supply and stoppage of the gas. Furthermore, the supply valve 16b can be configured to control the pressure of the gas, besides supply and stoppage of the gas.

For instance, in the case of producing a supersaturated gas solution, the pressure of the gas introduced into the tank 6a is set by the supply valve 16b to such a high pressure that the gas having a concentration higher than the solubility is dissolved.

The liquid supply section 16c supplies a liquid used to produce the treatment liquid 110.

For instance, the liquid supply section 16c supplies pure water.

The liquid supply section 16c can be e.g. a tank storing a liquid.

The supply valve 16d is provided between the liquid supply section 16c and the liquid feeder 16e.

The supply valve 16d controls supply and stoppage of the liquid. Furthermore, the supply valve 16d can be configured to control the flow rate of the liquid, besides supply and stoppage of the liquid.

The supply valve 16d can always maintain a constant amount of the liquid (treatment liquid 110) stored in the tank 6a based on the signal from the liquid-level meter, not shown, provided on the tank 6a.

The liquid feeder 16e is provided on the sidewall of the tank 6a. The liquid feeder 16e feeds the liquid from the liquid supply section 16c into the tank 6a.

The liquid feeder 16e can be e.g. a pump resistant to the liquid supplied from the liquid supply section 16c.

The foregoing has described the case where one kind of gas and one kind of liquid are supplied. However, two or more kinds of gas and two or more kinds of liquid may be supplied.

The tank 6a may be supplied with two or more kinds of liquid to produce the treatment liquid 110.

In the case where the treatment liquid 110 is APM, for instance, the tank 6a may be supplied with ammonia and hydrogen peroxide solution to produce the treatment liquid 110. In the case where the treatment liquid 110 is SPM, for instance, the tank 6a may be supplied with sulfuric acid and hydrogen peroxide solution to produce the treatment liquid 110.

That is, the tank 6a may be supplied with a plurality of raw materials to produce the treatment liquid 110.

The substrate treatment device 1a according to this embodiment can enjoy a function and effect similar to those of the aforementioned substrate treatment device 1.

The embodiments have been illustrated above. However, the invention is not limited to the above description.

Those skilled in the art can appropriately modify the above embodiments by addition, deletion, or design change of components, or by addition, omission, or condition change of steps. Such modifications are also encompassed within the scope of the invention as long as they include the features of the invention.

For instance, the shape, dimension, material, placement, number and the like of the components of the substrate treatment device 1, 1a are not limited to those illustrated, but can be appropriately changed.

In the above description, the laminated substrate 100 (substrate 100a) is heated, and then cooled. Instead, the laminated substrate 100 (substrate 100a) may be cooled in the temperature control section 4, and then heated by the treatment liquid 110 in the treatment bath 5a.

The temperature control section 4 described above is configured to mount the laminated substrate 100 (substrate 100a). The temperature control section 4 may have the function of heating the laminated substrate 100 (substrate 100a) by bringing a heating medium (gas, solution, or solid) into contact with the laminated substrate 100 (substrate 100a).

The temperature control section 4 may have the function of cooling the laminated substrate 100 (substrate 100a) by bringing a cooling medium (gas, solution, or solid such as dry ice) into contact with the laminated substrate 100 (substrate 100a).

The temperature control section 4 can be provided at a place spaced from the treatment bath 5a as described above. Alternatively, the temperature control section 4 can be provided in the treatment bath 5a, or provided in the treatment bath 5a and a place spaced from the treatment bath 5a.

For instance, heating and cooling may have already been performed before immersing the laminated substrate 100 (substrate 100a) in the treatment liquid 110. In this case, the temperature control section 4 can be configured so that the laminated substrate 100 (substrate 100a) is heated and then cooled with a circulated heat medium. The laminated substrate 100 (substrate 100a) can be heated and cooled by sequentially circulating the heated heat medium and cooled heat medium.

Alternatively, a heating medium and a cooling medium may be alternately sprayed from a nozzle onto the surface of the laminated substrate 100 (substrate 100a) by a known spinning device. That is, a peeling or crack due to difference in linear expansion coefficient may be produced at at least one of the interface between the device substrate 101 and the adhesive 102, and the interface between the support substrate 103 and the adhesive 102 before immersing the laminated substrate 100 (substrate 100a) in the treatment liquid 110.

In the case of providing the temperature control section 4 in the treatment bath 5a, the treatment liquid 110 can be provided with regions having different temperatures in the height direction of the treatment bath 5a.

FIG. 6 is a schematic sectional view for illustrating the treatment liquid 110 provided with regions having different temperatures.

In the case shown in FIG. 6, the treatment liquid 110 is provided with three regions having different temperatures. The temperature can be set to the highest in the topmost first region 110a, and decreased downward in the second region 110b and the third region 110c located below the first region 110a.

In this case, the laminated substrate 100 (substrate 100a) is heated by being held inside the first region 110a until the passage of a prescribed time. Subsequently, the laminated substrate 100 (substrate 100a) is further submerged and sequentially held inside the second region 110b and inside the third region 110c. Then, by the temperature difference between the regions, peeling is caused at at least one of the interface between the device substrate 101 and the adhesive 102, and the interface between the support substrate 103 and the adhesive 102.

That is, the laminated substrate 100 (substrate 100a) is heated and cooled by changing the height position of the laminated substrate 100 (substrate 100a) in the treatment bath 5a. This produces a thermal stress at at least one of the interface between the device substrate 101 and the adhesive 102, and the interface between the support substrate 103 and the adhesive 102. The thermal stress is based on the difference in linear expansion coefficient of the device substrate 101 and the support substrate 103 from the adhesive 102. The produced thermal stress produces e.g. a crack or gap. The treatment liquid 110 intrudes into the produced crack or gap. Thus, the adhesive 102 can be peeled from at least one of the device substrate 101 and the support substrate 103.

In this case, the temperature control section 4 for heating the treatment liquid 110 in the first region 110a can be provided in the treatment bath 5a.

In this case, the aforementioned control section 10 can control the relative position and the moving velocity of the laminated substrate 100 (substrate 100a) and the treatment liquid 110.

Alternatively, peeling may be performed so that the laminated substrate 100 (substrate 100a) is first held in the third region 110c and raised to the first region 110a. The temperature may be configured so as to increase from the first region 110a toward the third region 110c. The number of regions is not limited to three as long as two or more regions are provided.

The components of the embodiments described above can be combined with each other as long as feasible. Such combinations are also encompassed within the scope of the invention as long as they include the features of the invention.

### [Description of reference numerals]

- 1: substrate treatment device
- 1a: substrate treatment device
- 2: container
- 3: housing section
- 4: temperature control section
- 5: treatment section
- 5a: treatment bath
- 6: supply section
- 6a: tank
- 7: recovery section
- 8: transport section
- 9: transport section
- 10: control section
- 16: supply section
- 16a: gas supply section
- 16c: liquid supply section
- 100: laminated substrate
- 100a: substrate
- 101: device substrate
- 102: adhesive
- 103: support substrate
- 110: treatment liquid

## Claims

1. A substrate treatment device comprising:
a treatment bath configured to store a treatment liquid in which a treatment object is to be immersed;
a transport section configured to transport the treatment object; and
a temperature control section provided in at least one of the treatment bath and a position spaced from the treatment bath and configured to perform at least one of heating and cooling of the treatment object,
the treatment object being at least one of:
a laminated substrate including a device substrate, a support substrate, and an adhesive provided between the device substrate and the support substrate,
the device substrate with the adhesive attached thereto, and
the support substrate with the adhesive attached thereto.

2. The device according to claim 1, wherein the treatment liquid is at least one selected from the group consisting of pure water, ozone water, supersaturated gas solution, APM, and SPM.

3. The device according to claim 1, further comprising:
a control section configured to control the transport section,
wherein the control section controls the transport section so that the treatment object after being subjected to the at least one of heating and cooling in the temperature control section is immersed in the treatment liquid stored in the treatment bath.

4. The device according to claim 1, wherein the temperature control section provided in the treatment bath forms a plurality of regions having different temperatures in the treatment liquid stored in the treatment bath in height direction of the treatment bath.

5. The device according to claim 1, wherein the temperature control section forms a plurality of regions having different temperatures in a surface of the treatment object.

6. A peeling method for a laminated substrate, comprising:
changing temperature of the laminated substrate including a device substrate, a support substrate, and an adhesive provided between the device substrate and the support substrate; and
immersing the laminated substrate in a treatment liquid.

7. The method according to claim 6, wherein the treatment liquid is at least one selected from the group consisting of pure water, ozone water, supersaturated gas solution, APM, and SPM.

8. The method according to claim 6, wherein in the immersing the laminated substrate in the treatment liquid, the laminated substrate whose temperature has been changed in the changing the temperature is immersed in the treatment liquid.

9. The method according to claim 6, wherein
a plurality of regions having different temperatures are formed in the treatment liquid used for the immersing the laminated substrate in the treatment liquid, and
in the changing the temperature of the laminated substrate, the laminated substrate is moved between the plurality of regions having different temperatures.

10. The method according to claim 6, wherein in the changing the temperature of the laminated substrate, a plurality of regions having different temperatures are formed in a surface of a treatment object.

11. A method for removing an adhesive, comprising:
changing temperature of a device substrate with the adhesive attached thereto or a support substrate with the adhesive attached thereto; and
immersing the device substrate with the adhesive attached thereto or the support substrate with the adhesive attached thereto in a treatment liquid.

12. The method according to claim 11, wherein the treatment liquid is at least one selected from the group consisting of pure water, ozone water, supersaturated gas solution, APM, and SPM.

13. The method according to claim 11, wherein in the immersing in the treatment liquid, the device substrate with the adhesive attached thereto whose temperature has been changed or the support substrate with the adhesive attached thereto whose temperature has been changed is immersed in the treatment liquid to produce a thermal stress based on difference in linear expansion coefficient so that the treatment liquid easily intrudes into an interface between the device substrate and the adhesive or an interface between the support substrate and the adhesive.

14. The method according to claim 11, wherein
a plurality of regions having different temperatures are formed in the treatment liquid used for the immersing the device substrate with the adhesive attached thereto or the support substrate with the adhesive attached thereto in the treatment liquid, and
in the changing the temperature of the device substrate with the adhesive attached thereto or the support substrate with the adhesive attached thereto, the device substrate with the adhesive attached thereto or the support substrate with the adhesive attached thereto is moved between the plurality of regions having different temperatures.

15. The method according to claim 11, wherein in the changing the temperature of the device substrate with the adhesive attached thereto or the support substrate with the adhesive attached thereto, a plurality of regions having different temperatures are formed in a surface of a treatment object.
